# FASCICULE DE BREVET EUROPEEN

(11) **EP 1 098 364 B1**
(45) Date de publication et mention de la délivrance du brevet: **20.06.2007**
(21) Numéro de dépôt: 00410137.4
(22) Date de dépôt: 02.11.2000
(51) Int. Cl.: H01L 21/763, H01L 29/06

(54) **Procédé de fabrication de composants de puissance verticaux**
Herstellungsverfahren für vertikale Leistungskomponenten
Fabrication method for vertical power components

(30) Priorité: 03.11.1999 FR 9914012
(43) Date de publication de la demande: 09.05.2001
(73) Titulaire: STMicroelectronics S.A., 92120 Montrouge (FR)
(72) Inventeur: Auriel, Gérard, 37390 Chanceaux-sur-Choisille (FR); Cornibert, Laurent, 37000 Tours (FR)
(74) Mandataire: de Beaumont, Michel

(56) Documents cités:
- EP-A- 0 236 811
- EP-A- 0 521 558
- EP-A- 0 597 266
- FR-A- 2 675 310
- US-A- 5 049 521
- PATENT ABSTRACTS OF JAPAN vol. 006, no. 077 (E-106), 14 mai 1982 (1982-05-14) & JP 57 017145 A (FUJITSU LTD), 28 janvier 1982 (1982-01-28)

## Description

La présente invention concerne les composants de puissance de type vertical susceptibles de supporter des tensions élevées.

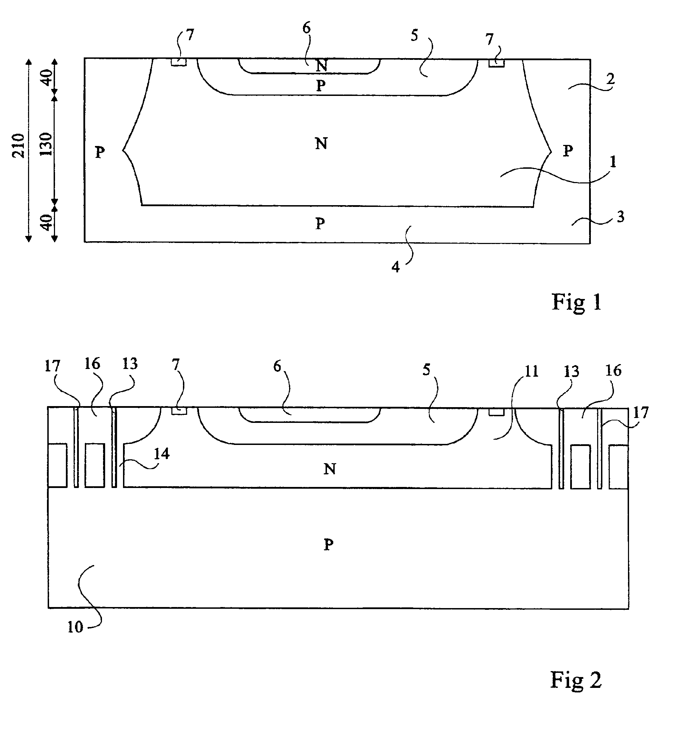

La figure 1 est une vue en coupe très schématique et partielle illustrant l'allure générale d'un composant de puissance classique. Ce composant est formé dans une plaquette de silicium de grande dimension et est entouré à sa périphérie externe d'un mur d'isolement du type de conductivité opposé à celui du substrat. Ce mur d'isolement est destiné à séparer le composant d'autres composants de la même puce, ou à créer une zone de protection électriquement inactive à la frontière d'une puce, là où est effectuée une découpe par rapport à une puce voisine. Plus particulièrement, si l'on considère la figure 1, en partant d'un substrat 1 de type N, une première opération de fabrication consiste à former à partir des faces supérieure et inférieure de ce substrat des régions de diffusion profondes 2 et 3 qui se rejoignent pour former le mur d'isolement.

Pour des raisons pratiques, les plaquettes ne peuvent pas avoir des épaisseurs inférieures à 200 µm. En dessous de ce seuil, elles seraient susceptibles de se briser trop facilement lors des manipulations liées à la fabrication. Ainsi, chacune des diffusions 2 et 3 doit pénétrer dans la plaquette d'une centaine de µm, par exemple 125 µm pour une plaquette d'une épaisseur de 210 à 240 µm, de façon à s'assurer de la formation d'un mur d'isolement continu et suffisamment dopé au niveau de sa partie médiane. Ceci implique des diffusions très longues à des températures élevées, par exemple 300 heures à 1280°C. Il est clair que cette opération doit être réalisée sur une plaquette de silicium avant toute autre opération de dopage de cette plaquette. Sinon, pendant cette longue durée de traitement thermique, les implantations préalablement réalisées dans le substrat diffuseraient trop profondément.

Après formation des murs d'isolement, on forme des régions dopées destinées à former le composant vertical souhaité, par exemple, comme cela est représenté en figure 1, un thyristor. Pour cela, on pourra réaliser simultanément, sur toute la face inférieure du substrat, une région 4 de type P correspondant à l'anode du thyristor et, sur une partie de la face supérieure du substrat, une région 5 de type P correspondant à la région de gâchette de cathode de ce thyristor. Ensuite, du côté de la face supérieure, on réalise une diffusion N⁺ pour former dans la région 5 une région de cathode 6 et éventuellement entre la région 5 et le mur d'isolement 2 un anneau périphérique 7 d'arrêt de canal. Des diffusions profondes sont par exemple décrites dans le document EP-A-521 558.

Comme on l'a vu précédemment, l'épaisseur totale de la plaquette est fixée par des considérations de fabrication, essentiellement mécaniques. Par ailleurs, les caractéristiques des régions de type P 4 et 5 sont fixées par les caractéristiques électriques souhaitées du thyristor qui déterminent le niveau de dopage et la profondeur de diffusion. En effet, on souhaite par exemple que le front de dopage entre chacune des régions 4 et 5 et le substrat 1 soit suffisamment raide pour améliorer les caractéristiques des jonctions correspondantes, et notamment pour obtenir une bonne caractéristique d'injection du transistor PNP au niveau de la jonction entre le substrat 1 et la région 4.

Ainsi, dans le cas du thyristor représenté, si chacune des diffusions 4 et 5 a une profondeur de l'ordre de 40 µm, et si la plaquette a une épaisseur de 210 µm, il restera entre les deux jonctions PN 5-1 et 4-1 une zone du substrat 1 d'une épaisseur de 130 µm. Comme cela est bien connu, c'est cette zone du substrat qui permet de conférer au dispositif de puissance ses caractéristiques de tenue en tension à l'état bloqué. Il faut donc que cette zone soit suffisamment épaisse. Par contre, le fait que cette zone soit trop épaisse entraîne que les pertes à l'état conducteur du dispositif de puissance augmentent. Si l'on veut réaliser un dispositif de puissance ayant une tenue en tension de l'ordre de 400 volts, il suffirait que l'épaisseur de la région de substrat 1 soit de l'ordre de 80 µm alors que, avec le procédé de fabrication décrit, on arrive inévitablement à une épaisseur de l'ordre de 130 µm. On ne connaît pas actuellement de façon simple de résoudre ce problème. En effet, augmenter par exemple l'épaisseur de la couche 4 entraîne que le profil de jonction de cette couche risque de ne pas satisfaire aux conditions électriques souhaitées.

De façon plus générale, le même problème se pose avec tout dispositif de puissance devant être entouré d'un mur d'isolement dont la face arrière est d'un type de dopage opposé à celui d'un substrat de tenue en tension, par exemple un transistor de puissance ou un transistor IGBT.

Ainsi, un objet de la présente invention est de prévoir un nouveau procédé de fabrication de composants de puissance destiné à optimiser l'épaisseur de la couche la plus faiblement dopée de tenue en tension.

La présente invention vise aussi un composant obtenu par le procédé décrit.

Pour atteindre ces objets, la présente invention prévoit un procédé de fabrication d'un composant de puissance vertical sur une plaquette de silicium comprenant les étapes consistant à faire croître une couche épitaxiale faiblement dopée d'un second type de conductivité sur la surface supérieure d'un substrat fortement dopé du premier type de conductivité et constituant une région active du composant, la couche épitaxiale ayant une épaisseur adaptée à supporter la tension maximale susceptible d'être appliquée au composant de puissance lors de son fonctionnement ; et délimiter dans la plaquette une zone correspondant à au moins un composant de puissance par un mur d'isolement formé en perçant une tranchée à travers la couche épitaxiale et en faisant diffuser à partir de cette tranchée un dopant du premier type de conductivité à fort niveau de dopage.

Selon un mode de réalisation de la présente invention, la tranchée est constituée d'ouvertures voisines suffisamment proches pour que les zones résultant de la diffusion du dopant du premier type de conductivité à fort niveau de dopage se rejoignent.

Selon un mode de réalisation de la présente invention, la tranchée est remplie de silicium polycristallin fortement dopé.

Selon un mode de réalisation de la présente invention, des murs d'isolement parallèles sont formés de part et d'autre de chaque zone de découpe des puces d'une même plaquette.

La présente invention prévoit aussi un composant de puissance vertical formé sur une plaquette de silicium comprenant une couche épitaxiale du deuxième type de conductivité à faible niveau de dopage formée sur un substrat du premier type de conductivité à fort niveau de dopage et constituant une région active du composant, dans lequel un mur d'isolement à la périphérie du composant de puissance est réalisé à partir d'une tranchée ou de perçages formés à travers la couche épitaxiale et de régions diffusées du premier type de conductivité à fort niveau de dopage s'étendant à partir de ladite tranchée ou desdits perçages.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 est une vue en coupe schématique d'un composant de puissance vertical de structure classique ; et
la figure 2 est une vue en coupe schématique d'un composant de puissance vertical obtenu par le procédé selon la présente invention.

Selon la présente invention, pour réaliser un composant de puissance, on part d'un substrat 10 de type P relativement fortement dopé sur lequel est formée par épitaxie une couche 11 de type N faiblement dopée destinée à constituer la couche de tenue en tension d'un composant de puissance vertical dont le substrat P constitue l'anode de face inférieure. Ensuite, pour réaliser un mur d'isolement, la présente invention prévoit de former une tranchée 13 traversant sensiblement l'épaisseur de la couche épitaxiale 11 et entourant le composant puis de faire diffuser un dopant 14 à partir de cette tranchée. Par exemple, la tranchée sera remplie de silicium polycristallin fortement dopé de type P et une étape de diffusion thermique sera effectuée. La durée nécessaire à la diffusion sera extrêmement courte par rapport à la durée nécessitée par les étapes de diffusion profonde verticale des murs d'isolement décrits en relation avec la figure 1.

Selon une variante de la présente invention, la tranchée est remplacée par des ouvertures suffisamment proches les unes des autres pour que les zones diffusées 14 s'étendant latéralement à partir de ces ouvertures se rejoignent et constituent le mur d'isolement. Les ouvertures peuvent par exemple avoir un diamètre de l'ordre de 1 à 5 µm et être distantes les unes des autres de 2 à 10 µm.

On notera qu'un procédé de diffusion profonde à partir de la surface supérieure pour former des murs d'isolement ne serait pas compatible avec l'existence d'un substrat épitaxié car cela entraînerait une rediffusion du dopant du substrat 10 dans la couche épitaxiée 11 qui entraînerait d'une part que l'épaisseur restante de la couche N serait mal déterminée et d'autre part que le front de la jonction entre la couche épitaxiale 11 de type N et le substrat 10 de type P serait très peu raide et donc que cette jonction présenterait de mauvaises caractéristiques d'injection.

Ensuite, on formera de façon classique des diffusions destinées à former un composant souhaité, par exemple une diffusion 5 de gâchette de cathode et des diffusions 6 et 7 de cathode et d'anneau d'arrêt de canal. De préférence, pour améliorer la qualité du mur d'isolement, en même temps que l'on forme la diffusion 5 de type P, on pourra procéder à une diffusion dans des zones 16 correspondant à la partie haute du mur d'isolement, pour augmenter le niveau de dopage à la surface supérieure du mur d'isolement.

En outre, on a représenté en figure 2 à titre d'exemple un deuxième mur d'isolement 17 externe au premier. Une découpe pourra être effectuée entre les deux murs d'isolement distants par exemple de 100 µm pour séparer deux puces d'une plaquette.

Selon un autre avantage de la présente invention, on notera que les murs d'isolement, dans les figures schématiques ci-jointes auront une étendue latérale beaucoup plus faible quand ils sont réalisés à partir de tranchées ou de perçages plutôt que de diffusions profondes.

Diverses variantes de perçages et de modes de réalisation des murs d'isolement apparaîtront à l'homme de l'art et certaines d'entre elles sont déjà connues dans la technique et par exemple décrites dans la demande de brevet français de la demanderesse N° 98/13544 du 23.10.1998 (B4124) (EP-A-997 931).

En outre, on a représenté à titre d'exemple et par souci de simplification un thyristor en figures 1 et 2. Bien entendu, l'invention s'appliquera également à toute autre structure de composant de puissance de type vertical dont la face arrière est de type opposé à celui d'une couche de tenue en tension et notamment à des structures de type transistors de puissance et transistors bipolaires à grille isolée (IGBT). Dans de telles structures, la présente invention permet d'obtenir une couche de tenue en tension ayant exactement l'épaisseur souhaitée, ne dépendant pas de contraintes technologiques.

La présente invention est susceptible de nombreuses variantes et modifications qui apparaîtront à l'homme de l'art. Par exemple, on pourra prévoir une étape de rodage de la face arrière des plaquettes après formation de la couche épitaxiée du côté de la face avant.

## Revendications

1. Procédé de fabrication d'un composant de puissance vertical sur une plaquette de silicium comprenant les étapes suivantes :
faire croître une couche épitaxiale faiblement dopée (11) d'un second type de conductivité sur la surface supérieure d'un substrat (10) fortement dopé du premier type de conductivité et constituant une région active du composant, la couche épitaxiale ayant une épaisseur adaptée à supporter la tension maximale susceptible d'être appliquée au composant de puissance lors de son fonctionnement ; et
délimiter dans la plaquette une zone correspondant à au moins un composant de puissance par un mur d'isolement formé en perçant une tranchée à travers la couche épitaxiale et en faisant diffuser à partir de cette tranchée un dopant du premier type de conductivité à fort niveau de dopage (14).

2. Procédé selon la revendication 1, **caractérisé en ce que** la tranchée est constituée d'ouvertures voisines (13) suffisamment proches pour que les zones résultant de la diffusion du dopant du premier type de conductivité à fort niveau de dopage se rejoignent.

3. Procédé selon la revendication 1 ou 2, **caractérisé en ce que** la tranchée est remplie de silicium polycristallin fortement dopé.

4. Procédé selon la revendication 1, **caractérisé en ce que** des murs d'isolement parallèles sont formés de part et d'autre de zones de découpe entre puces d'une même plaquette.

5. Composant de puissance vertical formé sur une plaquette de silicium comprenant une couche épitaxiale (11) du deuxième type de conductivité à faible niveau de dopage formée sur un substrat (10) du premier type de conductivité à fort niveau de dopage et constituant une région active du composant, dans lequel un mur d'isolement à la périphérie du composant de puissance est réalisé à partir d'une tranchée ou de perçages formés à travers la couche épitaxiale et de régions diffusées (14) du premier type de conductivité à fort niveau de dopage s'étendant à partir de ladite tranchée ou desdits perçages.

## Claims

1. A method for manufacturing a vertical power component on a silicon wafer, including the steps of:
growing a lightly-doped epitaxial layer (11) of a second conductivity type on the upper surface of a heavily-doped substrate (10) of a first conductivity type and constituting an active region of the component, the epitaxial layer having a thickness adapted to withstanding the maximum voltage likely to be applied to the power component during its operation; and
delimiting in the wafer an area corresponding to at least one power component by an isolating wall formed by etching a trench through the epitaxial layer and diffusing from this trench a dopant of the first conductivity type of high doping level (14).

2. The method of claim 1, wherein the trench is formed of neighboring openings (13) sufficiently close to one another for the areas resulting from the diffusion of the dopant of the first conductivity type of high doping level to join.

3. The method of claim 1 or 2, wherein the trench is filled with heavily-doped polysilicon.

4. The method of claim 1, wherein parallel isolating walls are formed on either side of each cutting area of the chips of a same wafer.

5. A vertical power component formed on a silicon wafer including an epitaxial layer (11) of the second conductivity type of low doping level formed on a substrate (10) of the first conductivity type of high doping level and constituting an active region of the component, in which an isolating wall at the periphery of the power component is formed from a trench or holes formed through the epitaxial layer and from diffused regions (14) of the first conductivity type with a high doping level extending from said trench or said holes.

## Patentansprüche

1. Ein Verfahren zur Herstellung einer vertikalen Leistungskomponente auf einem Siliziumwafer, wobei das Verfahren die folgenden Schritte aufweist:
Aufwachsen einer leicht dotierten Epitaxialschicht (11) auf einen zweiten Leitfähigkeitstyp auf der Oberseite eines stark dotierten Substrats (10) eines ersten Leitfähigkeitstyps und Ausbilden eines aktiven Bereichs der Komponente, wobei die Epitaxialschicht eine Dicke besitzt, die in der Lage ist, der maximalen Spannung, die wahrscheinlich während des Betriebs an die Leistungskomponente angelegt wird, zu widerstehen; und
Einschränken eines Bereichs in dem Wafer, der der wenigstens einen Leistungskomponente entspricht durch eine Isolierwand, die gebildet wird durch Ätzen eines Grabens durch die Epitaxialschicht und Diffundieren von diesem Graben eines Dotiermittels des ersten Leitfähigkeitstyps mit hohem Dotierniveau (14).

2. Verfahren nach Anspruch 1, wobei der Graben aus benachbarten Öffnungen (13) gebildet ist, die ausreichend nahe aneinander liegen, so dass sich die Bereiche, die aus der Diffusion des Dotiermittels mit dem ersten Leitfähigkeitstyp mit hohem Dotierniveau verbinden

3. Verfahren nach Anspruch 1 oder 2, wobei der Graben mit einem stark dotierten Polysilizium gefüllt ist.

4. Verfahren nach Anspruch 1, wobei parallele Isolierwände auf jeder Seite jedes Schneidbereichs der Chips eines selben Wafers ausgebildet sind.

5. Eine vertikale Leistungskomponente, die auf einem Siliziumwafer ausgebildet ist, einschließlich einer Epitaxialschicht (11) des zweiten Leitfähigkeitstyps mit niedrigem Dotierniveau, die auf einem Substrat (10) des ersten Leitfähigkeitstyps mit hohem Dotierniveau ausgebildet ist, und einen aktiven Bereich der Komponente bildet, wobei eine Isolierwand an dem Umfang der Leistungskomponente von einem Graben oder Löchern, die durch die Epitaxialschicht hindurch und aus diffundierten Bereichen (14) des ersten Leitfähigkeitstyps mit einem hohen Dotierniveau, welche sich von dem Graben oder den Löchern erstrecken, gebildet wird.
